# EUROPEAN PATENT APPLICATION

(11) **EP 3 809 456 A1**
(43) Date of publication of application: **21.04.2021**
(21) Application number: 19819510.9
(22) Date of filing: 11.06.2019
(51) Int. Cl.: H01L 21/8239, H01L 27/105, H01L 45/00, H01L 49/00

(54) **CONDUCTIVE-BRIDGE MEMORY DEVICE AND PRODUCTION METHOD THEREFOR, AND SWITCH ELEMENT**

(30) Priority: 12.06.2018 JP 2018112008
(71) Applicant: National University Corporation Tottori University, Tottori-shi, Tottori 680-8550 (JP); Nagase & Co., Ltd., Osaka 550-8668 (JP)
(72) Inventor: ITOH, Toshiyuki, Tottori-shi, Tottori 680-8550 (JP); NOKAMI, Toshiki, Tottori-shi, Tottori 680-8550 (JP); KINOSHITA, Kentaro, Tokyo 162-8601 (JP); MORII, Shigeki, Tokyo 103-8355 (JP)
(74) Representative: Brann AB
(86) International application number: PCT/JP2019/023143
(87) International publication number: WO 2019/240139

(57) **Abstract**

A high-performance CB-RAM having a low operating voltage and a high switching endurance even when alumina is used for the insulator layer (3) is provided. In a conductive bridge memory device, an electrolyte layer (4) impregnated in a pore (3a) of an insulator layer 3 is configured to be comprising a mixed ionic liquid in which is mixed a solvate ionic liquid, and a low-viscous ionic liquid being an ionic liquid having a viscosity coefficient smaller than that of the solvate ionic liquid.

## Description

### TECHNICAL FIELD

The invention relates to a conductive bridge memory device, a manufacturing method thereof, and a switching element.

### BACKGROUND ART

CB-RAM (Conducting bridge random access memory) or an atom switch has a simple structure of an electrode A /a solid electrolyte (a memory layer) /an electrode B, in which a solid metal oxide material having nano-sized pores, such as HfO₂, SiO₂, Al₂O₃, GeSe, or Ag₂S, is sandwiched by the electrode A, composed of an electrochemically active metal (for example, Ag or Cu), and the electrode B, composed of an inactive metal (for example, Pt). By applying a positive voltage to the electrode A (with respect to the electrode B), atoms constituting the electrode A are ionized and penetrate into nanopores in the solid electrolyte and move toward the electrode B. Metal ions reaching the electrode B receive electrons, and are deposited as a metal. As a result, a filament-shaped conductive path is formed inside the solid electrolyte, the filament-shaped conductive path being composed of the metal constituting the electrode A, and the electrode A and the electrode B being connected causes a low resistance state to be realized. On the other hand, applying a negative voltage to the electrode A (with respect to the electrode B) causes constituent atoms of the electrode A constituting the filament to be ionized. The orientation of the electric field is reverse that at the time of forming the filament, so that atoms constituting the filament are recovered by the electrode A, causing a high resistance state to be restored. In other words, the CB-RAM being capable of replacing the resistance value change by "1" and "0" signals to function as a memory has excellent features such as high speed, high integration, and low power consumption, so that this element is expected as a replacement for a flash memory to face the minituarization limit in the near future and as a universal memory having both high speed and non-volatility. The high resistance state of the CB-RAM can be assumed to be the "OFF" state since current is difficult to flow therein, while the low resistance state thereof is assumed to be the "ON" state since current is easy to flow therein. Thus, the CB-RAM can be used not only as a memory device but also as a switch, and the conductive path is composed of a metal, so that it is superior in current transport characteristics, the possibility thereof for an atom transistor is expected, and the application thereof to a circuit changeover switch for FPGA (field programmable gate array) is also expected.

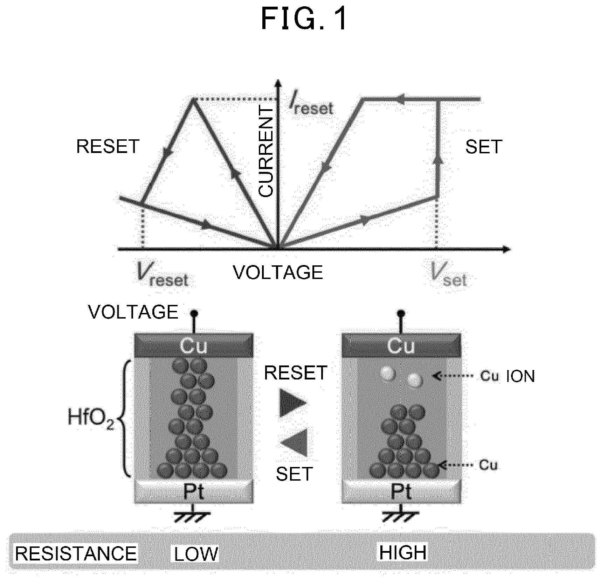

FIG. 1 schematically shows a cross section of Cu /a metal oxide /Pt and a switching process. Here, the metal oxide is set to be HfO₂ (hafnia). Here, as shown in FIG. 1, the Pt electrode is grounded, while a voltage is applied to the Cu electrode. A bipolar operation was confirmed in which a positive bias being applied to the Cu electrode causes "set" (resistive switching from high to low resistance) and a negative bias being applied thereto causes "reset" (resistive switching from low to high resistance). The function in which the CB-RAM repeats the set-reset resistive switching is exhibited via a filament forming process called "forming". While the current-voltage characteristics for the forming is similar to the current-voltage characteristics for the set, a forming voltage (V_{form}) being the voltage at which the forming occurs is generally higher than the voltage at which the set occurs (Vₛₑₜ).

In recent years, various ionic liquids being a liquid molten salt at room temperature have come to be known. An ionic liquid being a molten salt exhibits conductivity, and component ions thereof are tightly bound mutually by the Coulomb force, so that it exhibits non-volatility and fire resistance. Moreover, in accordance with the constituent ions thereof, it can be used as liquid having the function to dissolve various inorganic and organic compounds (see Non-patent document 1).

The inventors have revealed that impregnating an ionic liquid in a metal oxide layer makes it possible to carry out a design of a stable and high-performance CB-RAM (see Patent document 1, Non-patent documents 1, 2, 3, 4, 5). In a case that an ionic liquid is impregnated in an HfO₂ (hafnia) layer of a Cu/HfO₂/Pt cell, stabilization of the hafnia layer in switching operation improved markedly, and adding therein an ionic liquid containing 5000 ppm of moisture resulted in a salient stabilization such that destruction of the hafnia device did not occur at all even when a voltage of greater than or equal to 10V was applied thereto (see Non-patent documents 1, 2). Then, they have studied the design of an ionic liquid to be added and have revealed that an ionic liquid having a high ionic conductivity and having an anion with a low proton acceptability can decrease the set voltage (Vₛₑₜ) and the reset voltage (Vᵣₑₛₑₜ) (see Non-patent document 3). In a case that only an ionic liquid was added to the hafnia layer of the Cu/HfO2/Pt cell, the Vₛₑₜ, V_{form} and Vᵣₑₛₑₜ decreased, but no improvement in the switching endurance was recognized.

The resistance value change of a CB-RAM is caused by a metal filament formed in a metal oxide layer. Therefore, in a CB-RAM in which a metal oxide layer is sandwiched by a Cu foil and a Pt substrate, a copper filament produced by electrodeposition in the metal oxide layer is a primary cause for bringing about the resistance value change. Then, it was found that the switching endurance improved remarkably when a Copper(II) bis (trifluoromethyl) sulfonyl (Cu (TFSA)₂) solution of 1-Butyl-3-methylimidazolium bis (trifluoromethyl)sulfonylamide ([Bmim][TFSA]) in which Cu²⁺ ions are incorporated in an ionic liquid in advance was added to the hafnia layer (Non-patent documents 2, 3, 4). While, on the other hand, it was found that Vₛₑₜ, Vᵣₑₛₑₜ increased slightly. It was found that, when a solvate ionic liquid composed of 2,5,8,11-tetraoxadodecane (G3) [Cu-G3-(TFSA)₂] (see Non-patent document 5) was impregnated in the hafnia layer to solve this problem, Vₛₑₜ, Vᵣₑₛₑₜ decreased slightly despite [Cu-G3-(TFSA)₂] being extremely high in viscosity and, even more, the switching endurance greatly improved (see Non-patent document 5).

"TFSA" is also abbreviated as [Tf₂N], and is also often denoted, in reagent catalogs and documents, as "bis(trifluoromethylsulfonyl)imide" ([TFSI]). However, "imide" is specified in the IUPAC nomenclature as "an amido compound which connected with two carbonyl group", so that [Tf₂N] being named as "bis(trifluoromethylsulfonyl) amide" is correct when naming it in accordance with the IUPAC nomenclature. It can be said that "(trifluoromethylsulfonyl)imide" is the naming according to the IUPAC rules. In the specification, [TFSA] will be used in accordance with the IUPAC nomenclature.

### PRIOR ART DOCUMENT

### Patent Document

Patent Document 1: JP 6195155 B1

### Non-patent document

Non-patent document 1: Harada, A.; Yamaoka, H.; Ogata, R.; Watanabe, K.; Kinoshita,K.; Kishida, S.; Nokami, T.; Itoh, T. J. Mater. Chem. C, 2015, 3, 6966-6969.
Non-patent document 2: Harada, A.; Yamaoka, H.; Watanabe, K.; Kinoshita, K.; Kishida, S.; Fukaya, Y.; Nokami, T.; Itoh, T.Chem. Lett., 2015, 44, 1578-1580.
Non-patent document 3: Harada, A.; Yamaoka, H.; Tojo, S.; Watanabe, K.; Sakaguchi, A.; Kinoshita, K.; Kishida, S.; Fukaya,Y.; Matsumoto, K.; Hagiwara, R.; Sakaguchi, H.; Nokami, T.; Itoh, T. J. Mater. Chem. C, 2016, 4, 7215-7222.
Non-patent document 4: Kinoshita, K.; Sakaguchi, A.; Harada, A.; Yamaoka, H.; Kishida, S.; Fukaya, Y.; Nokami, T.; Itoh, T. Jpn. J. Appl. Phy. 2017, 56, 04CE13.
Non-patent document 5: Yamaoka, H.; Yamashita, T.; Harada, A.; Sakaguchi, A.; Kinoshita, K.; Kishida, S.; Hayase, S.; Nokami, T.; Itoh, T. Chem. Lett. 2017, 46, 1832-1835.

### SUMMARY OF THE INVENTION

### PROBLEM TO BE SOLVED BY THE INVENTION

While impregnating a solvate ionic liquid in a hafnia layer as a metal oxide layer made it possible to achieve a stable and high-performance CB-RAM structure to an acceptable degree as described previously, it was found that, in a case of a Cu /Al₂O₃/ Pt cell in which a metal oxide is replaced by Al₂O₃ (alumina), satisfying both reducing Vₛₑₜ and Vᵣₑₛₑₜ, and improving the switching endurance is not possible even when any one of an ionic liquid, a copper salt containing ionic liquid, and a solvate ionic liquid having a copper ion as the central metal ion [Cu-G3-(Tf₂N)₂] is impregnated therein. Therefore, the invention allows solving such problems in CB-RAM and to provide a core technology to realize a high-performance CB-RAM.

In other words, the invention is to provide a guideline to realize an optimal ionic liquid design to be added to a metal oxide layer to develop a high-performance metal oxide CB-RAM being capable of driving at a low voltage and having a high switching endurance, and to provide a device configuration to realize the desired switching characteristics. In particular, it is to provide a guideline for an ionic liquid design capable of utilizing an inexpensive metal oxide such as alumina, which inexpensive metal oxide has not attracted attention conventionally.

### MEANS TO SOLVE THE PROBLEM

A conductive bridge memory device being one embodiment of the invention includes: a first metal layer including an electrochemically active and easily ionizable metal; a second metal layer including an electrochemically stable metal; an insulating layer being sandwiched between the first metal layer and the second metal layer and having a pore communicating from a first surface being in contact with the first metal layer to a second surface being in contact with the second metal layer; and an electrolyte layer being impregnated in the pore of the insulator layer, wherein the electrolyte layer includes a mixed ionic liquid in which is mixed a solvate ionic liquid, and a low-viscous ionic liquid being an ionic liquid having a viscosity coefficient smaller than that of the solvate ionic liquid.

A switching device being another embodiment of the invention includes: a first metal layer including an electrochemically active and easily ionizable metal; a second metal layer including an electrochemically stable metal; an insulating layer being sandwiched between the first metal layer and the second metal layer and having a pore communicating from a first surface being in contact with the first metal layer to a second surface being in contact with the second metal layer; and an electrolyte layer being impregnated in the pore of the insulator layer, wherein the electrolyte layer includes a mixed ionic liquid in which is mixed a solvate ionic liquid, and a low-viscous ionic liquid being an ionic liquid having a viscosity coefficient smaller than that of the solvate ionic liquid, wherein conduction/non-conduction between the first metal layer and the second metal layer can be controlled in accordance with the polarity of a voltage applied between the first metal layer and the second metal layer.

A manufacturing method for a conductive bridge memory device being yet another embodiment of the invention includes: forming an insulating layer on a surface of a first metal layer including an electrochemically active and easily ionizable metal, in which insulating layer a first surface is in contact with the surface of the first metal layer, the insulating layer having a pore communicating between the first surface and a second surface being opposite to the first surface; impregnating, in the pore of the insulating layer, an electrolyte material including a mixed ionic liquid in which is mixed a solvate ionic liquid, and a low-viscous ionic liquid being an ionic liquid having a viscosity coefficient smaller than that of the solvate ionic liquid; and forming, on the second surface of the insulating layer in which the mixed ionic liquid is impregnated, a second metal layer composed of an electrochemically stable metal.

### EFFECTS OF THE INVENTION

According to the invention, adjusting a solvent intermediating diffusion of atoms of a first metal layer constituting an electrode A makes it possible to control resistive switching characteristics, or, in particular, voltage or current causing resistive switching to occur, allowing to reduce power required to cause resistive switching to occur and variation in the switching voltage. This makes it possible to improve switching endurance. Moreover, there is an advantage that replacing water being easy to evaporate and to be electrolyzed, the water being present in an insulator having a pore, such as an oxide polycrystalline film grain boundary or a porous body, with a non-volatile and electrochemically unstable mixed ionic liquid makes it possible to suppress degradation of an insulator layer such as a metal oxide and make a stable CB-RAM or atom switch.

### BRIEF DESCRIPTION OF THE DRAWINGS

FIG. 1 shows a view explaining the schematic structure of a Cu/metal oxide/Pt CB-RAM and the principles of the switching process.
FIG. 2 shows a schematic structural view of a Cu/HfO₂/Pt cell according to one embodiment of the invention.
FIG. 3 shows viscosity measurement results at each temperature according to the type of mixed ionic liquid.
FIG. 4 shows results of TG measurement (thermal weight measurement) according to the type of mixed ionic liquid.
FIG. 5 shows switching endurance testing results of Cu/Al₂O₃/Pt cell at the time of use in a case that the Cu concentration of the mixed ionic liquid is changed.
FIG. 6 shows the cumulative probability of a forming voltage (V_{form}) of the Cu/Al₂O₃/Pt cell at the time of adding the mixed ionic liquid in a case that the mixing ratio of the mixed ionic liquid is changed.
FIG. 7 shows the cumulative probability distribution of a set voltage (Vₛₑₜ) of the Cu/Al₂O₃/Pt cell at the time of adding the mixed ionic liquid in a case that the mixing ratio of the mixed ionic liquid is changed.
FIG. 8 shows the viscosity at each temperature of Cu-containing DME and so on and G2 solvate ionic liquids.
FIG. 9 shows results of a TG measurement with respect to the temperature in a case of changing the mixing ratio of the Cu-containing DME and the G2 solvate ionic liquids.
FIG. 10 shows the forming voltage (V_{form}) distribution of the Cu /Al₂O₃/ Pt cell at the time of adding in a case of changing the mixing ratio of the Cu-containing DME and the G2 solvate ionic liquids.
FIG. 11 shows the cumulative probability distribution of the set voltage (Vₛₑₜ) of the Cu /Al₂O₃/ Pt cell in a case of changing the type or the ratio of the Cu-containing DME and the G2 solvate ionic liquids.
FIG. 12 shows the switching endurance of a Cu /Al₂O₃/ Pt element in a case of changing the type or the mixing ratio of the Cu-containing DME and the G2 solvate ionic liquids.
FIG. 13 shows the distribution of the set voltage (Vₛₑₜ) of the Cu /Al₂O₃/ Pt cell in a case of changing the Ag amount of Ag [TFSA]-containing [Bmim][TFSA].
FIG. 14 shows the switching endurance of the Cu /Al₂O₃/ Pt element with Ag [TFSA]-containing [Bmim][TFSA].
FIG. 15 shows a circuit diagram of an exemplary configuration of a memory device according to one embodiment of the invention.
FIG. 16 shows cross-sectional views of a manufacturing process for the memory device according to one embodiment of the invention.

### EMBODIMENT FOR CARRYING OUT THE INVENTION

### [First embodiment]

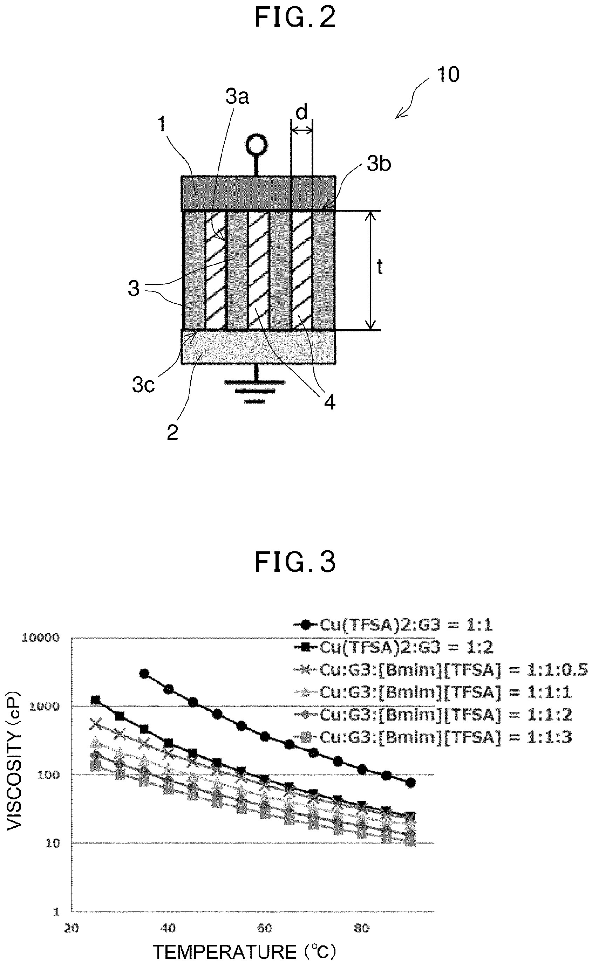

A conductive bridge memory device according to a first embodiment of the invention will be described with reference to FIG. 2. A memory cell 10 of the conductive bridge memory device according to the embodiment, as shown with the structure of one example thereof in FIG. 2, comprises: a first metal layer 1 (an electrode A) including an electrochemically active and easily ionizable metal; a second metal layer 2 (an electrode B) including an electrochemically stable metal; an insulating layer 3 being sandwiched between the first metal layer 1 and the second metal layer 2 and having a pore communicating between a first surface 3b being in contact with the first metal layer 1 and a second surface 3c being in contact with the second metal layer 2; and an electrolyte layer 4 being impregnated in the pore 3a of the insulator layer 3. Then, the electrolyte layer 4 contains a mixed ionic liquid in which is mixed a solvate ionic liquid, and a low-viscous ionic liquid being an ionic liquid having a viscosity coefficient smaller than that of the solvate ionic liquid. To make the explanations easy to understand, FIG. 2 shows, as the insulator layer 3, an example of the pore 3a portion and the insulator layer 3 being divided by a porous body of hafnia (HfO₂), in which porous body the pore 3a tends to have a columnar shape. However, as described below, the insulator layer 3 including a porous body of alumina, in which porous body the pores 3a are mutually connected in a complex shape, also act in the same manner. It suffices that the pore 3a of the insulator layer 3 communicates between the first surface 3b being in contact with the first metal layer 1 and the second surface 3c being in contact with the second metal layer 2. In the specification, the term "communicate" means being mutually connected to such a degree that at least liquid can pass through regardless of the shape of the pore. In other words, the pores continue such that liquid can pass therethrough between the first surface 3b and the second surface 3c.

Here, "solvate" means the state in which molecules of a solvent surround the periphery of molecules or ions of a solute in a solution to create a group of molecules. The solvate ionic liquid means such an ionic liquid having solvate. Moreover, the term "a low-viscous ionic liquid" is a name to be referred to for the sake of convenience in the specification, and means an ionic liquid having a smaller viscosity (viscosity coefficient) than that of the solvate ionic liquid. Furthermore, the term "a mixed ionic liquid" also being a name to be referred to for the sake of convenience in the specification means an ionic liquid in which is mixed the solvate ionic liquid and the above-described low-viscous ionic liquid.

As described previously, the inventors have made an arduous study in quest for performance improvement of the conductive bridge memory device (CBRAM). As a result, impregnating an ionic liquid as the electrolyte layer 4 to be impregnated in the pore 3a of the insulating layer 3 including a porous body have made it possible to switch between on and off at high speed. However, there is a problem that the operating voltages such as the set voltage (Vₛₑₜ) increase, and, as a result of an arduous study by the inventors, it was found that the cause thereof is that a Cu²⁺ ion covers the surface of the second metal layer 2 and the following Cu²⁺ ion is difficult to reach the second metal layer 2, and that there is a need to increase the applying voltage. Then, it was found that, as a countermeasure therefor, making the electrolyte to be a solvate ionic liquid in which a Cu²⁺ ion is surrounded by a solvent made it possible to substantially decrease the operating voltages such as the set voltage (Vₛₑₜ). However, a problem occurred that, even when such a solvate ionic liquid was used, in a case of using an inexpensive oxide layer such as alumina (Al₂O₃) as the insulator layer 3, the switching speed decreased and the switching endurance decreased. Thus, the inventors made a further arduous study to solve this problem.

In other words, it was found the cause thereof lies in that, when using the solvate ionic liquid as the electrolyte layer 4, the viscosity of the solvate ionic liquid is large and the speed of the Cu²⁺ ion decreases in the pore 3a being formed in a complex shape, such as in alumina, due to attraction by the Coulomb force. Then, impregnating, in the pore 3a of the insulator layer 3, as a mixed ionic liquid in which is mixed, into a solvate ionic liquid, a low-viscous ionic liquid being a so-called normal ionic liquid, the low-viscous ionic liquid having the viscosity lower than that of the solvate ionic liquid, made it possible to obtain a conductive bridge memory device having a low operating voltage and having an excellent switching endurance.

As a solvent of the solvate ionic liquid to be used as the electrolyte layer 4 according to the embodiment, at least one type of solvent is used, the at least one type of solvent to be selected from the group consisting of: 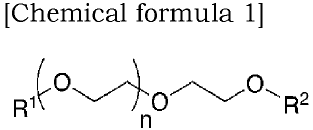 and 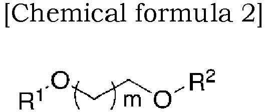 (where n is the number of ethyleneoxy groups being 1 or 2; m is the number of methylene groups, which is an integer being any one of 1 to 3; each of R¹, R² can be the same or different; R¹ denotes an alkyl group whose number of carbons is between 1 and 6, an alkenyl group whose number of carbons is between 2 and 6, an alkylnyl group whose number of carbons is between 2 and 6, a trimethysilyl group, a triethysilyl group, or a t-butyldimethylsilyl group; R² denotes an alkyl group whose number of carbons is between 1 and 16, an alkenyl group whose number of carbons is between 2 and 6, an alkylnyl group whose number of carbons is between 2 and 6, a trimethysilyl group, a triethysilyl group, or a t-butyldimethylsilyl group; and the alkenyl group can contain therein an ether functional group, a thioether functional group.)

While a metal ion being a solute constituting the solvate ionic liquid is desirably a copper ion that can be a filament component, it is not necessary to stick to a component metal constituting a filament (a metal of the first metal layer 1). For example, a metal ion such as a precious metal ion species, for example, a silver ion, a gold ion, a palladium ion, a rhodium ion, a ruthenium ion, or a platinum ion, or cobalt, nickel, or a lanthanoid metal ion such as Europium (Eu) can be utilized. Moreover, a plurality of these metal ions can be mixed. In other words, even in a case that copper is used as a material for the metal layer 1 and the filament is formed of copper, the above-mentioned various metal ions can be used as a solute of the solvate ionic liquid, or a copper ion and these metal ions can be mixed. The ratio of the metal ions of the solvate ionic liquid with respect to the overall metal constituting the filament is very small.

While a counter anion constituting the solvate ionic liquid is desirably bis(trifluoromethylsulfonyl) amide (N(SO₂CF₃)₂⁻:TFSA), bis(fluorosulfonyl)amide (N(SO₂F)₂⁻:FSA), it suffices to be an anion species to be liquid when solvated, and the other ones include AlCl₄⁻, BF₄⁻, PF₆⁻, SbF₆⁻, MeSO₃⁻, CF₃SO₃⁻, NO₃⁻, CF₃COO⁻, RCOO⁻, RSO₄⁻, RCH(NH₂)COO⁻, SO₄²⁻, ClO₄⁻, (HF)_{2.3}F. (Here, R denotes H, an alkyl group, or an alkyloxy group).

Moreover, as the low-viscous ionic liquid, for example, the at least one type to be selected from the group consisting of: 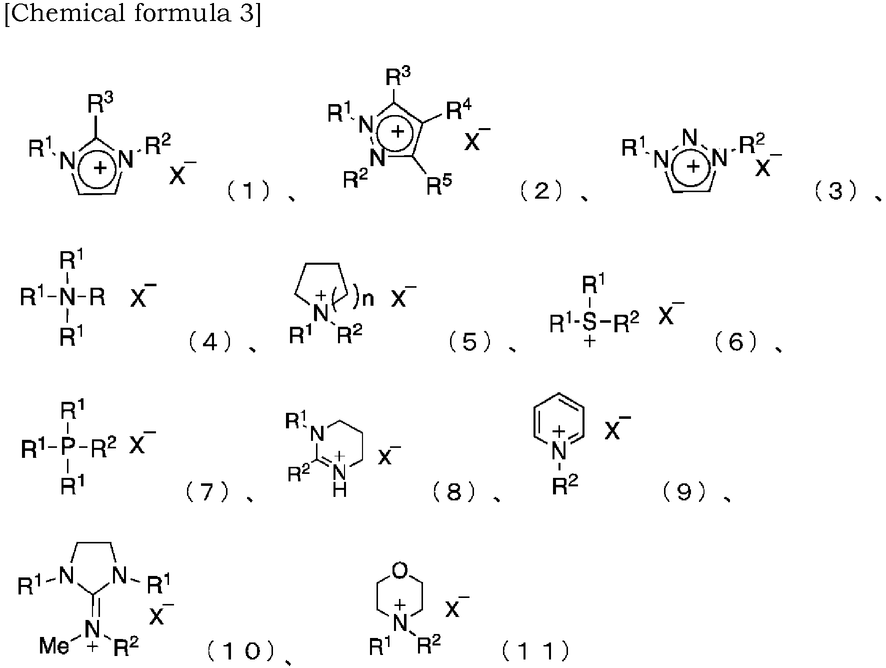 can be used.
(where R¹ can be the same or different in the above-mentioned respective chemical formulas, and denotes an alkyl group whose number of carbons is between 1 and 6, or an alkenyl group whose number of carbons is between 2 and 6; R² can be the same or different in the above-mentioned respective chemical formulas, and denotes a hydrogen atom, an alkyl group whose number of carbons is between 1 and 16, an alkenyl group whose number of carbons is between 2 and 6, or an alkoxy group. The alkenyl group can contain therein an ether functional group, a thioether functional group. R³ can be the same or different in the above-mentioned respective chemical formulas, and denotes a hydrogen atom, a phenyl group, a methyl group, or an isopropyl group. n in chemical formula (5) denotes the number of methylene units, where n=1 or 2. In chemical formula (8), R¹ and R² can have carbon chains connected mutually, in which case they denote a trimethylene group, a tetramethylene group, a pentamethylene group, a hexamethylene group, or a heptamethylene group. Anion (X) in the ionic liquid can be the same or different in the above-mentioned respective chemical formulas, and denotes AlCl₄⁻, BF₄⁻, PF₆⁻, SbF₆⁻, N(SO₂CF₃)₂⁻, N(SO₂F)₂⁻, N(CN)₂⁻, MeSO₃⁻, MeSO₄⁻, CF₃SO₃⁻, NO₃⁻, CF₃COO⁻, RCOO⁻, RSO₄⁻, RCH(NH₂)COO⁻, SO₄²⁻, ClO₄⁻, Me₂PO₄⁻, (HF)_{2.3}F⁻. (Here, R denotes H, an alkyl group, or an alkyloxy group.)

As a further specific example of a cation and an anion constituting the low-viscous ionic liquid, 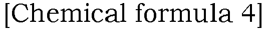 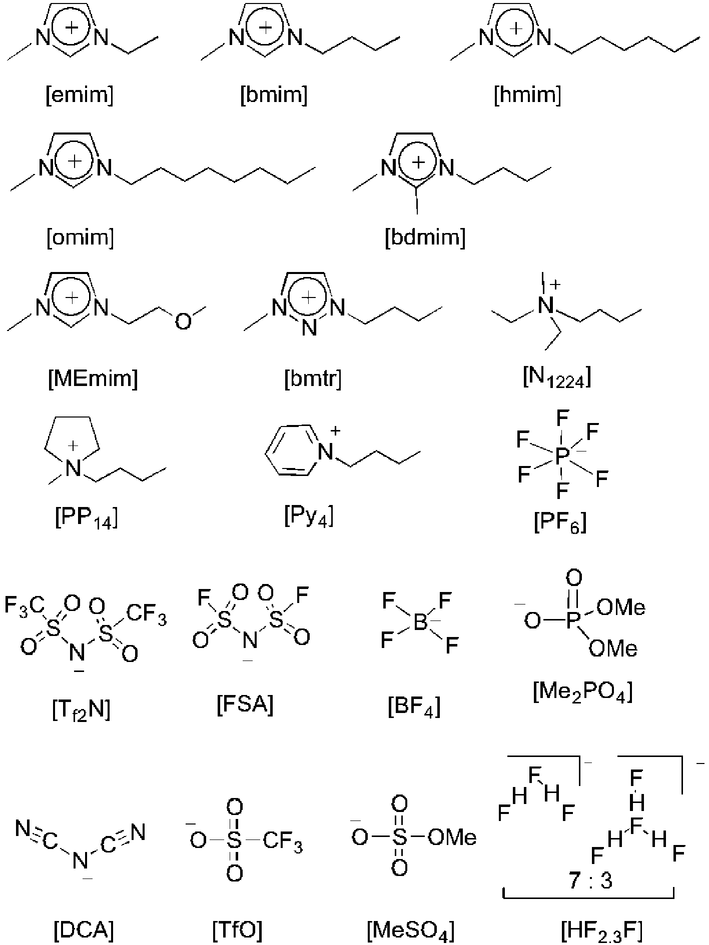 can be used.

The above-mentioned solvate ionic liquid or the low- viscous ionic liquid is not limited to the one type in the above-mentioned example, but can be a mixture of a plurality of types in the above-mentioned example. Moreover, while the mixing ratio (the molar ratio) of the solvate ionic liquid and the low-viscous ionic liquid is adjusted as needed in accordance with such as the type of the pore 3a of the insulating layer (metal oxide layer) 3 to be used, as a preferable range, for example, the ratio of (the solvate ionic liquid) : (the low-viscous ionic liquid) is 1: (1 to 3).

Moreover, as a result of the inventors having made a further arduous study, it was found that incorporating, in the solvate ionic liquid, or a low-viscous ionic liquid, or a mixed ionic liquid in which these are mixed, a metal salt to be dissolved therein makes it possible to further improve the CB-RAM function.

It is not necessary to stick to a metal constituting a filament, or, in other words, a metal of the first metal layer 1, as a cation of a metal salt to be dissolved in the mixed ionic liquid, the metal salt to improve the CB-RAM function as described in the above, so that the metal salt can be a metal salt capable of being dissolved in the low-viscous ionic liquid or the solvate ionic liquid. In this case, a metal having a smaller ionization tendency than that of the metal of the first metal layer 1 is desirable. In other words, in a case that copper is used as the metal layer 1, a silver salt, a gold salt, a palladium salt, a rhodium salt, a ruthenium salt, or a platinum salt is possible, for example. Adding the silver salt in particular makes it possible to substantially improve the CB-RAM function. Moreover, this metal salt can be not only a mono salt, but also a double salt.

While, as an anion of a metal salt to improve the CB-RAM function as described in the above and to be dissolved in the mixed ionic liquid, bis(trifluoromethylsulfonyl)amide (N(SO₂CF₃)₂⁻:TFSA), bis(fluorosulfonyl)amide (N(SO₂F)₂⁻:FSA) are desirable, it suffices that it be an anion species to be liquid when solvating with a metal ion, and the other ones include AlCl₄⁻, BF₄⁻, PF₆⁻, SbF₆⁻, MeSO₃⁻, CF₃SO₃⁻, NO₃⁻, CF₃COO⁻, RCOO⁻, RSO₄⁻, RCH(NH₂)COO⁻, SO₄²⁻, ClO₄⁻, (HF)_{2.3}F (Here, R denotes H, an alkyl group, or an alkyloxy group). Moreover, a plurality of these anions can be mixed.

The low-viscous ionic liquid or the solvate ionic liquid containing the metal salt or the metal ion to improve the CB-RAM function can be a single mixed ionic liquid or a plurality of mixed ionic liquids, or a solvate ionic liquid containing different types of metal ions, so that there is a need to adjust and optimize the mixing ratio in accordance with the metal oxide layer to be used.

Examples of the types of mixing between the solvate ionic liquid and the low-viscous ionic liquid and the mixing ratio thereof will be described later in the specific examples.

As described previously, the structure of the CB-RAM according to the embodiment is configured to be the structure in which the insulator layer 3 having the pore 3a to communicate between the first surface 3b and the second surface 3c is sandwiched between the first metal layer 1 and the second metal layer 2. As the first metal layer 1, an electrochemically active and easily ionizable metal is used. Specifically, a metal such as Cu, Ag, Ti, Zn, V, or an alloy of these metals can be cited. Moreover, as a metal for the second metal layer 2, an electrochemically stable metal is used. Specifically, a metal such as Pt, Au, Ir, Ru, Rh, or an alloy of these metals can be cited.

For the insulator layer 3 having the pore 3a, a polycrystalline or amorphous of a solid metal oxide or a semiconductor oxide having a nano-sized pore, such as alumina, hafnia, GeSe, or Ag₂S, and a porous body being formed by a self-assembling phenomenon, such as a metal organic framework, can be cited. As described previously, the example shown in FIG. 2 is an example of hafnia (HfO₂), the example being an example in which the pore 3a is formed in a columnar shape. While the pore 3a is not formed in the columnar shape in a case of the porous body being alumina (Al₂O₃), it suffices that the pores 3a be mutually connected between the first surface 3b and the second surface 3c and the pores 3a in which filaments continue be formed between the first metal layer 1 and the second metal layer 2. In other words, it suffices that the pore 3a be communicated between the first surface 3b and the second surface 3c, so that the insulator layer 3 does not have to be a porous body. Therefore, alumina is preferable in that it is inexpensive and easy to obtain, and it suffices that the insulator layer 3 have mutually connecting pores 3a. For example, the insulator layer 3 can also be an amorphous insulator. In the example shown in FIG. 2, the diameter d of the pore 3a is approximately between 2 to 5 nm, while the thickness t of the porous body is approximately between 2 to 50 nm. While the pore 3a is not formed in a columnar shape even in a case of alumina (Al₂O₃), the size thereof is approximately the same as in a case of hafnia.

The size of the pore 3a of the porous body is, preferably, greater than or equal to 0.1 nm and less than or equal to 30 nm, and the porosity thereof is, preferably, greater than or equal to 10% and less than or equal to 80%. The previously-described liquid electrolyte material is impregnated in the pore 3a of the insulator layer 3. As methods of impregnating this electrolyte material in the pore 3a of the insulator layer 3, for example, an electrolyte material can be applied to the surface of the insulator layer 3 having the pore 3a to impregnate the applied electrolyte material thereto using a capillary phenomenon, an electrolyte material can be dropped onto the surface of the insulator layer 3 to vacuum suction the dropped electrolyte material from the rear surface, or the insulator layer 3 having the pore 3a is dipped in an electrolyte material liquid to cause the dipped insulator layer 3 to be impregnated therein.

As described previously, adding an electrolyte material in the insulator layer 3 (a metal oxide layer) makes it possible to improve the CB-RAM function such as the forming voltage (V_{form}), the set voltage (Vₛₑₜ); the reset voltage (Vᵣₑₛₑₜ), and the switching endurance, and, as the above-mentioned electrolyte material, a metal salt-containing ionic liquid can be selected. While a metal salt was dissolved in a single ionic liquid (either a low-viscous ionic liquid or a solvate ionic liquid) to realize an improvement in the CB-RAM function in the prior art Patent document 1 and studies (Non-patent documents 1 to 5), the invention was completed by making a metal salt-containing ionic liquid to improve the CB-RAM function using a technique to mix a plurality of ionic liquids being a solvate ionic liquid and a low-viscous ionic liquid and to optimize the mixing ratio thereof. Next, further explanations will be given using specific examples.

### [Making of element]

A CB-RAM element was made by impregnating, in the pore 3a of an Al₂O₃ film having a thickness of 20nm (a porous body), a mixed ionic liquid in which is mixed Cu(TFSA)₂ and Triglyme(G3) as a solvate ionic liquid and [Bmim][TFSA] as a low-viscous ionic liquid (written below as Cu(TFSA)₂-Triglyme(G3)-[Bmim][TFSA]). Specifically, the Al₂O₃ film was formed on a Pt thin film (the second metal layer 2) by sputtering, and 1 µl (microliter) each of the solvate ionic liquid and the low-viscous ionic liquid was dropped thereon, and a Cu-probe was brought into contact with an Al₂O₃ thin film through this ionic liquid layer instead of the first metal layer 1 in FIG. 2 to form a Cu/HfO₂/Pt cell. The forming voltage (V_{form}), the set voltage (Vₛₑₜ); the reset voltage (Vᵣₑₛₑₜ), and the switching endurance were measured using this element. In this experiment, to avoid the effect of water in the atmosphere, a dry N₂ gas was supplied into a measurement container from 15 minutes prior to measurement, and a resistance change at the time of applying voltage was investigated in the dry N₂ gas atmosphere. At least 20 points were measured for one cell.

### [Viscosity, conductivity of mixed ionic liquid]

When measurements were carried out for Cu(TFSA)₂:G3:[Bmim][TFSA]=1:1:0.5, 1:1:1, 1:1:2, 1:1:3 (molar ratio) samples, as shown in FIG. 3, as the amount of [Bmim][TFSA] in the mixed ionic liquid increased, the conductivity improved with the decrease in the viscosity. It was revealed that the viscosity decreased and the conductivity increased by mixing of the solvate ionic liquid and the ionic liquid [Bmim][TFSA] (see Table 1), and it was revealed that the viscosity and the conductivity could be controlled by mixing of the solvate ionic liquid and an imidazolium salt ionic liquid.

### [Table 1]

**Table 1. VISCOSITY/CONDUCTIVITY OF Cu-CONTAINING MIXED ION LIQUIDS**

| | Cu(TFSA) ₂: G3=1:1 | Cu(TFSA)₂: G3=1:2 | Cu(TFSA)₂: G3 : [Bₘᵢₘ][TFSA] mixing ratio | | | |
|---|---|---|---|---|---|---|
| | | | 1:1:0.5 | 1:1:1 | 1:1:2 | 1:1:3 |
| VISCOSITY (cP)/35°C | 3023 | 470.1 | 284.8 | 165.0 | 111.7 | 80.27 |
| CONDUCTIVITY (mS/cm)/30°C | 0.080 | 0.48 | 0.74 | 1.0 | 1.6 | 2.3 |

### [Thermal stability measurement of mixed ionic liquid]

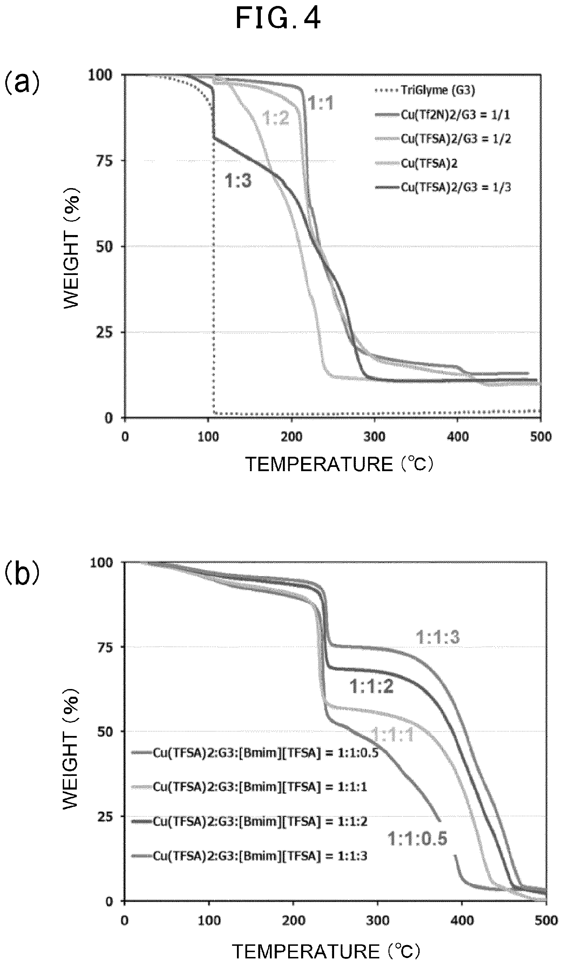

Results of TG measurement of mixed ionic liquids in each of which a low-viscous ionic liquid (an imidazolium salt ionic liquid ionic liquid) is mixed in a solvate ionic liquid, by comparison with Cu(TFSA)₂-G3 ionic liquids, are shown in FIG. 4. It was revealed that, while a large weight decrease occurred in the vicinity of 230 to 240 degrees C in the mixed ionic liquids, all exhibited improvement in thermal stability with respect to G3 alone and Cu(TFSA)₂ alone.

### [Switching endurance testing results at the time of adding mixed ionic liquid to Cu/Al₂O₃/Pt element]

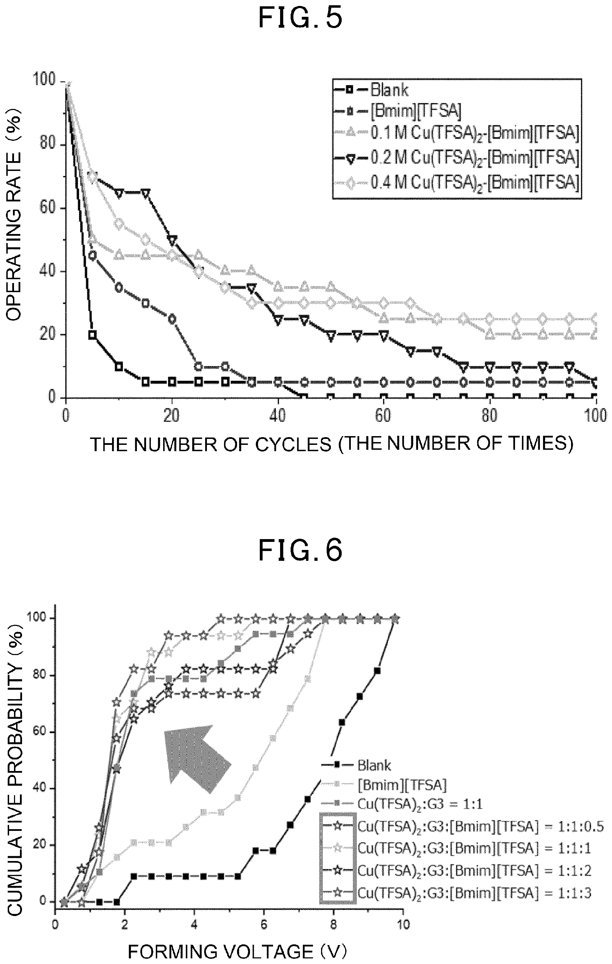

The switching endurance is shown in FIG. 5. All exhibited improvement with respect to Blank or Cu(TFSA)₂:G3= 1:1. Comparing in accordance with the type of mixed ionic liquid, the Cu(TFSA)₂:G3:[Bmim][TFSA]=1:1:2 exhibited the highest operating rate. The difference in the switching endurance is believed to be affected by the Cu concentration in the samples and the viscosity of the samples. First, with respect to the Cu concentration, as seen in the case of the Cu ion-dissolved ionic liquid or the Cu(TFSA)₂-G3 solvate ionic liquid in the hafnia device, securing a sufficient Cu concentration to suppress segregation of a filament is believed to be a factor in stabilizing rupture-formation of the filament. While the switching endurance improved with an increase in the Cu concentration in the hafnia element (see Non-patent documents 3, 4, 5), it only improved slightly in the alumina element. It is well known that, when comparing alumina and hafnia, alumina is more likely to be amorphous at the time of film formation, and a crystalline grain boundary is more difficult to be formed in alumina. In 1:1:0.5 and 1:1:1 having a higher Cu concentration with respect to 1:1:2 exhibiting the highest operating rate, it is believed that formation-rupture of the filament unstabilized due to the high viscosity and the difficulty of entry into a nanopore being formed in the alumina. On the other hand, it is believed that, while penetrating into a pore in the alumina is easy as the viscosity decreased in 1:1:3, the Cu concentration being the essence is low, thus limiting the impact on the formation-rupture process stabilization of the filament.

### [V_{form} measurement experiment at the time of adding mixed ionic liquid to Cu/Al₂O₃/Pt element]

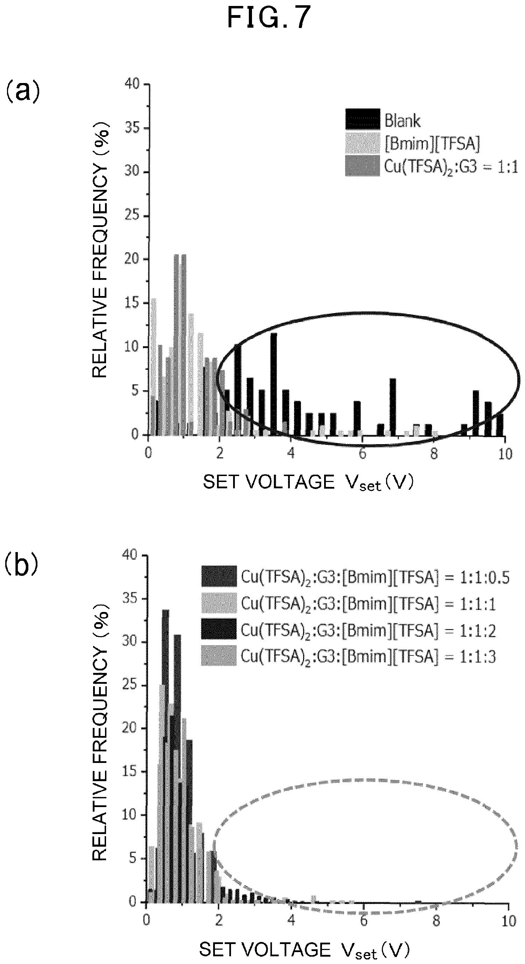

A forming voltage at the time of adding the mixed ionic liquid is shown in FIG. 6, while a set voltage is shown in FIG. 7. Both the forming voltage and the set voltage substantially improved. With respect to the forming voltage, 1:1:1 and 1:1:3 exhibited particularly superior results. These results are believed to be affected by the solution resistance (Rsol) and the charge transfer resistance (Rct). Rsol tends to decrease and Rct tends to increase as the amount of [Bmim][TFSA] in the mixed ionic liquid increases. It is believed that, with respect to the mixing ratio 1:1:3, Rsol is very low, so that the forming voltage decreases to compensate for the increase in Rct, while, with respect to the mixing ratio 1:1:1, values of Rsol and Rct adapted to the decrease in the forming voltage. Moreover, an excessive set voltage being observed in the case of an ionic liquid not being added (Blank) dramatically decreased with adding of a mixed ionic liquid. In this way, it was found that the operating voltage of an Al₂O₃ element could be improved substantially by using a mixed ionic liquid.

### [Type of solvate ionic liquid]

It is believed that while G3 (n=2 in Chemical formula 1) has been used conventionally as an ether compound to make a solvate ionic liquid (see Non-patent documents 5, 6, 7), besides G3, various ethers capable forming a complex with Cu ions can be utilized. For example, (Diglyme: G2) being denoted with n=1 in Chemical formula 1 and dimethoxyethane (DME) being denoted with n=1 in Chemical formula 2 are also expected to be utilized. Thus, the demonstration experiments thereof were carried out.

### [Viscosity measurement of solvate ionic liquids using DME, G2]

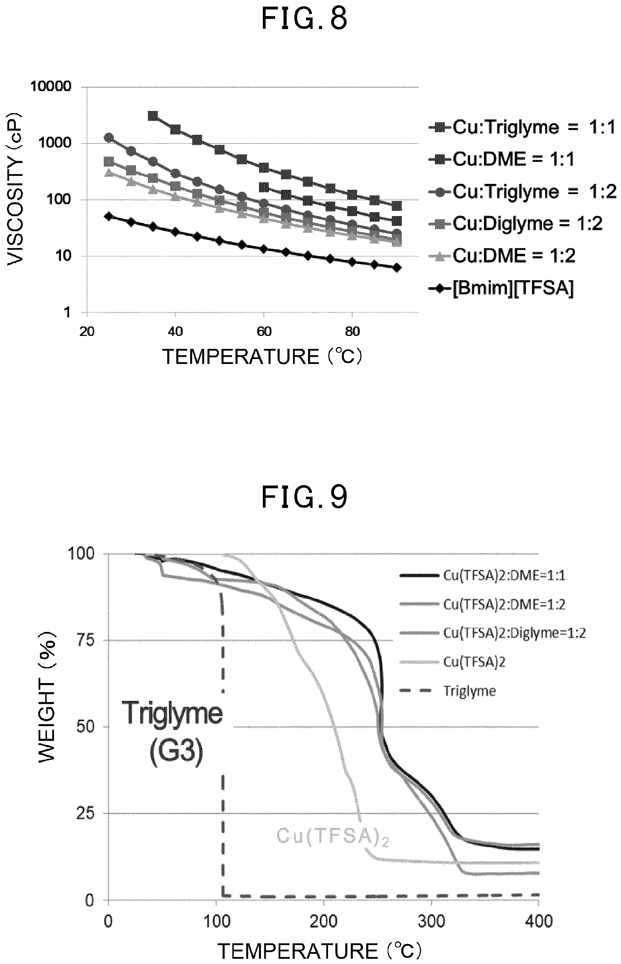

Viscosity measurement results of solvate ionic liquids using DME, G2 are shown in FIG. 8 while comparison of the viscosity and the conductivity are shown in Table 2. The viscosity decreased by using DME and G2 having a shorter side chain than that of G3, and the conductivity improved in conjunction therewith.

### [Table 2]

**Table 2. VISCOSITY/CONDUCTIVITY OF Cu-CONTAINING DME, G2 SOLVATED ION LIQUIDS**

| | [Bmim] [TFSA] | Cu:G3 1 :1 | Cu:G3 1:2 | Cu:DME 1:1 | Cu:DME 1:2 | Cu:G2 1:2 |
|---|---|---|---|---|---|---|
| VISCOSITY (cP)/35°C | 32.8 | 3023 | 470.1 | 165.9* | 155.2 | 241.2 |
| CONDUCTIVITY (mS·cm⁻¹)/30°C | 4.7 | 0.08 | 0.48 | 0.26 | 1.2 | 0.81 |

### [Thermal stability measurement experiment of Cu-containing DME, G2 solvate ionic liquids]

FIG. 9 shows TG measurement results of the Cu-containing DME, G2 solvate ionic liquids. Both Cu(TFSA)₂-DME and Cu(TFSA)₂-G2 improved in thermal stability with respect to Cu(TFSA)₂ alone or G3 alone.

### [Forming and set voltages of Cu /Al₂O₃/ Pt CB-RAM at the time of adding Cu-containing DME, G2 solvate ionic liquids]

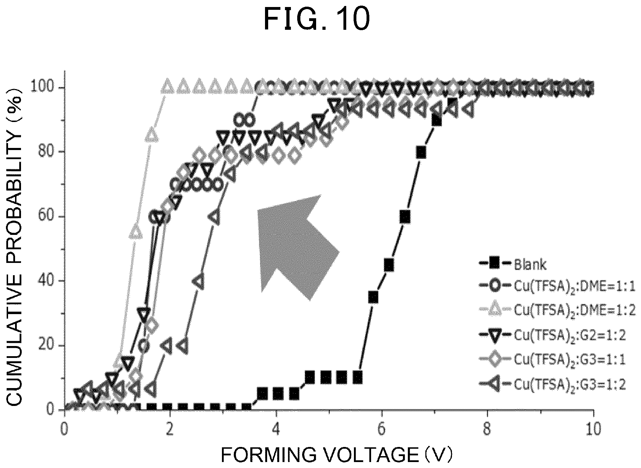

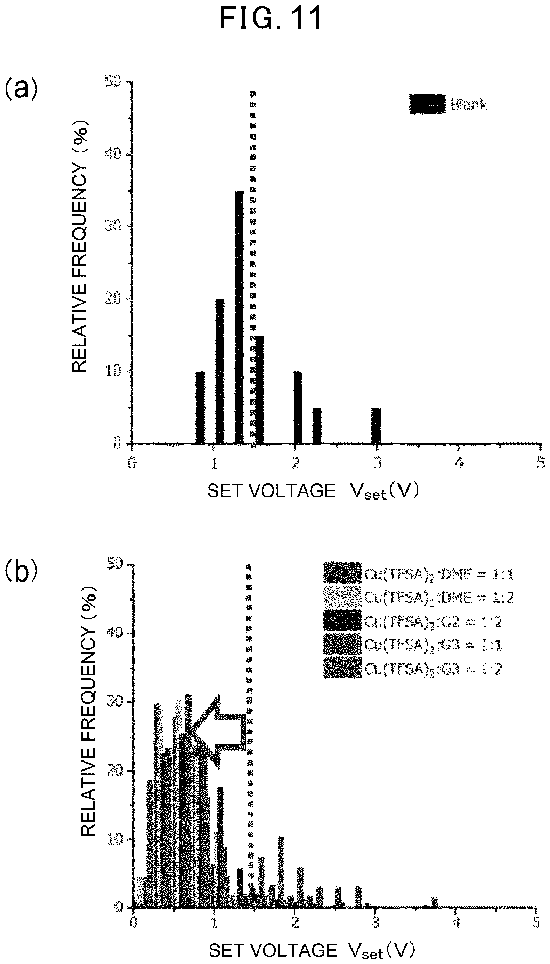

The forming voltage distribution of the Cu /Al₂O₃ /Pt cell at the time of adding the Cu-containing DME, the G2 solvate ionic liquids is shown in FIG. 10, while the set voltage distribution thereof is shown in FIG. 11. Both decreased when a solvate ionic liquid was added to the alumina layer. With respect to the forming voltage, Cu(TFSA)₂:DME=1:2 was particularly superior. This is believed to be caused by the fact that it has the highest conductivity of the solvate ionic liquids used. With respect to the set voltage, as shown in FIG. 11, using the solvate ionic liquid caused the set voltage thereof to be shifted overall to the low voltage side. It was found, from these results, that using the G2, DME solvate ionic liquids makes it possible to decrease the operating voltage.

### [Switching endurance of Cu /Al₂O₃ /Pt device to which is added Cu-containing DME, G2 solvate ionic liquids]

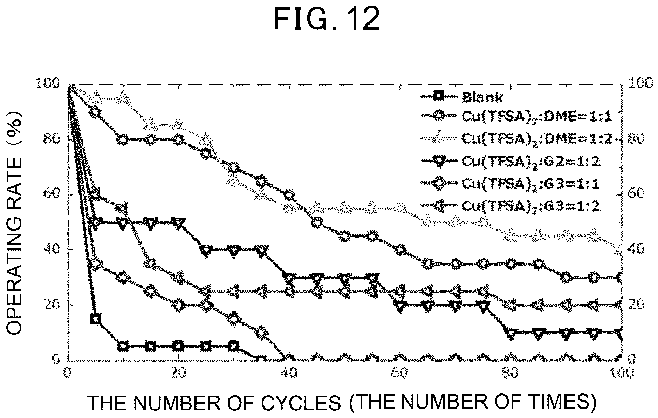

The switching endurance is shown in FIG. 12. Cu(TFSA)₂-DME solvate ionic liquid improved in particular. Comparing among the Cu(TFSA)₂-G3 solvate ionic liquids, Cu(TFSA)₂:G3=1:2 having a lower viscosity and a higher conductivity exhibited the highest operating rate and, even comparing among the Cu(TFSA)₂-DME solvate ionic liquids, Cu(TFSA)₂:DME=1:2 similarly exhibited the higher operating rate. This shows that facility of movement of copper ions is more effective in the CB-RAM switching resistance in the Al₂O₃ element in which a clear crystalline grain boundary is difficult to be formed. The Cu(TFSA)₂-DME solvate ionic liquid has a smaller ion pair size with respect to that of the Cu(TFSA)₂-G3 solvate ionic liquid. Therefore, besides the viscosity, the size of the solvate ionic liquid could also be related as a reason that the Cu(TFSA)₂-DME solvate ionic liquid exhibited superior results in the switching endurance. It is believed that the movement of a solvate ionic liquid having a small ion pair size be advantageous at a complex crystalline grain boundary as in the Al₂O₃ element and rupture-formation of a filament brought about stabilization.

### [Set voltage (Vₛₑₜ) in case of adding Ag [TFSA]-containing [Bmim][TFSA] to Cu /Al₂O₃/ Pt cell]

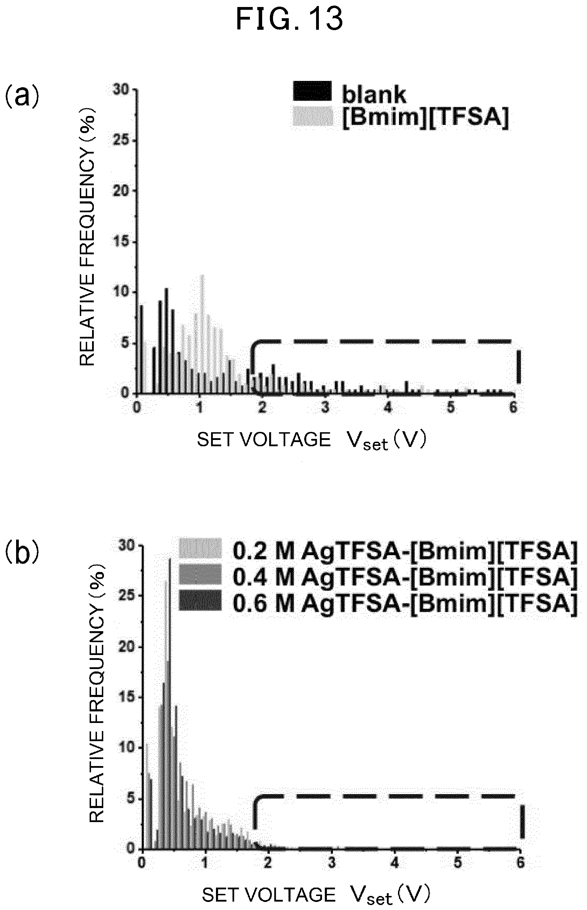

As a metal salt to be dissolved in a metal salt-containing ionic liquid to improve the CB-RAM function, there is no need to stick to a metal constituting a filament; the above-mentioned metal salt can be a metal salt capable of being dissolved in an ionic liquid or a solvate ionic liquid, so that it is possibly a salt of a metal being more precious than copper, for example, a silver salt, a gold salt, a palladium salt, a rhodium salt, a ruthenium salt, or a platinum salt. Adding a silver salt (Ag(TFSA))-containing low-viscous ionic liquid [Bmim][TFSA] to a Cu /Al₂O₃/ Pt device to demonstrate this (FIG. 13) causes the set voltage (Vₛₑₜ) to decrease, and no abnormal voltage was observed. While this is a model experiment and the mixed ionic liquid-type is not measured, similar results are believed to be obtained by adding Ag (TFSA) to a mixed ionic liquid.

### [Switching endurance of Cu/Al₂O₃/Pt element with Ag[TFSA]-containing [Bmim][TFSA]]

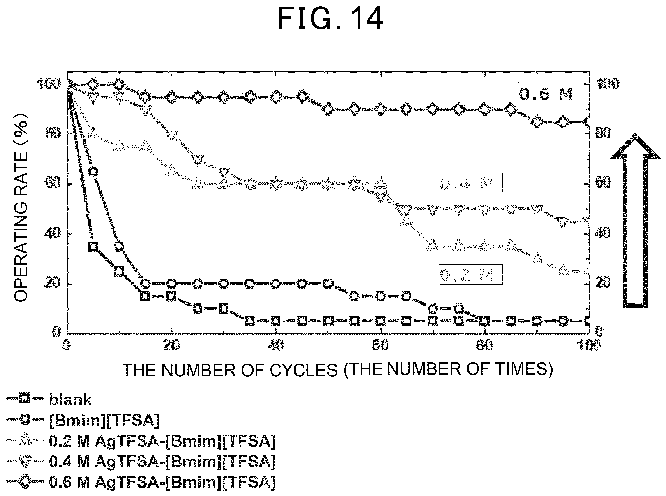

FIG. 14 shows results of investigating the switching endurance with an Ag [TFSA]-containing low-viscous ionic liquid [Bmim] [TFSA] being added in the Cu /Al₂O₃/ Pt element. As shown in this figure, the switching endurance of the Cu /Al₂O₃/ Pt device greatly improved. While this is a model experiment and the mixed ionic liquid-type is not measured, similar results are believed to be obtained by adding Ag (TFSA) to a mixed ionic liquid.

### [Configuration of memory device]

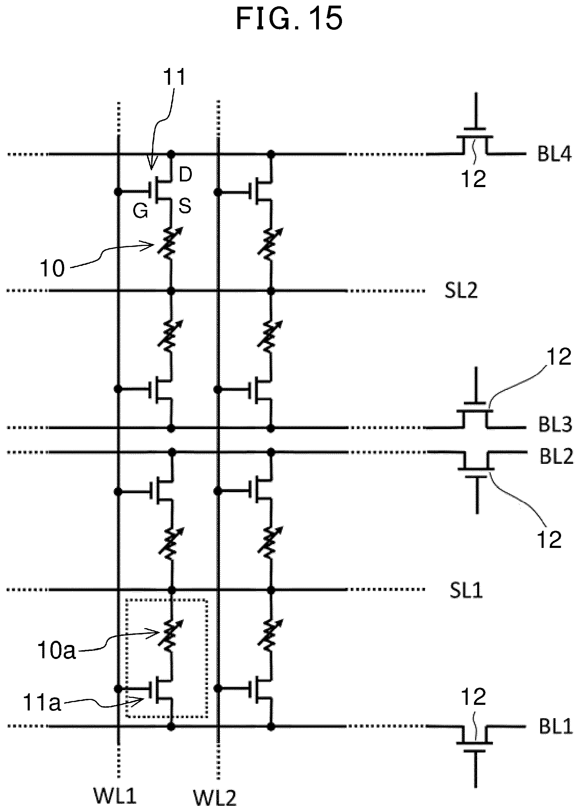

A normal memory device is configured by memory cells 10 (CB-RAM devices) being arranged in a matrix, the memory cells 10 being formed as described in the above and shown in FIG. 2, a selection transistor 11 being connected to each of the cells, and a word line WL being connected to a gate G of the above-mentioned selection transistor 11, a bit line BL being connected to a drain D thereof, and a source line SL (a signal line) being connected, via a memory cell 10, to a source S thereof, as shown in an equivalent circuit diagram in FIG. 15. Then, each of the memory cells 10 in a matrix being selected in accordance with desired data makes it possible to carry out displaying a desired image or storing in a predetermined location. In FIG. 15, the letter 12 denotes a bit line selection transistor.

Here, the CB-RAM device 10 according to the embodiment is a non-volatile storage device capable of exhibiting a reversible change in electrical resistance by an electrical stress, for example, applying a direct current or a pulse voltage, and storing information in correspondence with a resistance by the resistance being held even when power is turned off, so that, for example, as a CB-RAM device, the structure in which Al₂O₃, SiO₂, NiO_{y}(y=1), TiO_{z}, HfO_{z}(z=2) or the like being formed using such as sol-gel, sputtering, or MOCVD method is sandwiched between an active electrode (an electrode A) and an inactive electrode (an electrode B) is made.

While the previously-described configuration of the memory cell array can be set to be the same as the configuration shown in JP 4684297 B1, JP4662990 B1, or JP6108559 B1, in a memory device (a memory cell array) according to the embodiment, an insulator layer including an oxide layer having a mesopore or a nanopore in a memory layer of a CB-RAM device being used for the memory layer, a mixed ionic liquid being impregnated in such a pore, and absorbing and holding a solvent that can affect the electrochemical action and the movement of a metal ion is different from the conventional structure. According to the embodiment, absorbing and holding a mixed ionic liquid is different from the conventional one. It is preferable to contain a different metal salt or metal ion in this mixed ionic liquid.

### [Manufacturing method for memory device]

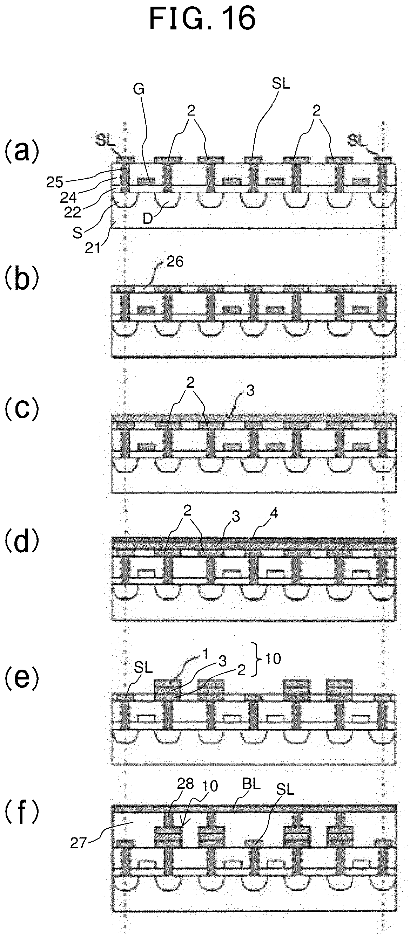

FIG. 16 shows manufacturing steps for a non-volatile memory device according to the embodiment. In the manufacturing method for the memory device according to the embodiment, first, as shown in (a) in FIG. 16, a transistor 11 having a source S, a drain D, and a gate G is formed on a surface of a semiconductor substrate 21 using a normal semiconductor process. Then, thereon an interlayer insulating film 24 is formed and a contact plug 25 is formed, and each of a source line SL on the contact plug 25 being connected to the source S and a second metal layer (an electrode B) 2 on the contact plug 25 being connected to the drain D is formed. For the second metal layer 2, for example, Pt was formed to a thickness of 100 nm under the conditions of the atmospheric gas of Ar:O₂=1:0, the total pressure of 0.7 Pa, and room temperature. In (a) in FIG. 15, the letter 22 denotes a gate insulating film.

Then, as shown in (b) in FIG. 16, an interlayer insulating film 26 being composed of such as SiO₂ (an Si thermal oxide film), for example, is formed between the source line SL and the second metal layer 2. Thereafter, as shown in (c) in FIG. 16, an insulator layer 3 being composed of a porous body such as hafnia or alumina, the porous body having a mesopore or a nanopore, for example, is formed. Specifically, with the substrate temperature at approximately 300 degrees C, the total pressure at 5. 3 Pa, and Ar:O₂ at the ratio of 3.8: 1.5, HfO₂ is formed to 20 nm, for example, on the electrode B (for example, Pt) using reactive RF magnetron sputtering method. Here, it is important that the HfO₂ thin film undergoes a polycrystalline growth and a crystalline grain boundary is introduced into the thin film.

Thereafter, as shown in (d) in Fig. 16, the mixed ionic liquid 4 as described previously is applied to the insulator layer 3 composed of the porous body by the mixed ionic liquid 4 being dropped thereon. Specifically, for example, [Bmim], [TFSA] being a low-viscous ionic liquid and Cu(TFSA)₂ and Triglyme(G3) being a solvate ionic liquid are uniformly applied, by spin coating, on the insulator layer 3 composed of the porous body as described previously, causing the applied liquid to be absorbed in a HfO₂ thin film grain boundary crystalline grain of the porous body functioning as a mesopore or a nanopore in the atmosphere or under low pressure. In particular, under low pressure, replacement between the moisture being capillary condensed in the crystalline grain boundary and the mixed ionic liquid is carried out efficiently.

Then, as shown in (e) in FIG. 16, a first metal layer (an electrode A) 1 is formed using such as copper and patterned to cause each of the memory cells 10 to be formed. With respect to forming of the first metal layer, specifically, a Cu film is formed to a thickness of 100 nm under the conditions of the atmospheric gas of Ar:O₂=1:0, the total pressure of 0.7 Pa, and room temperature. Next, as shown in (f) in FIG. 16, an interlayer insulating film 27 being composed of such as SiO₂ is formed so as to cover the surrounding of each of the cells 10 therewith. Then, the memory device according to the embodiment is completed by a contact plug 28 connected to the first metal layer 1 being formed in the interlayer insulating film 27 and a bit line BL being formed on the surface thereof so as to connect each contact plug 28.

A cross-sectional view of the Cu/HfO₂/Pt structure being made by forming Pt (the electrode B) on the interlayer insulating film 26 composed of SiO₂ as described in the above, and then an HfO₂ thin film (a porous body) and a film of Cu (the electrode A) is shown in FIG. 2. It can be seen that HfO₂ grows in a columnar shape and a nano-sized gap (grain boundary) is present in between columnar-shaped crystals.

While not shown in FIG. 16, the gate line GL (see FIG. 15) to connect the gate G of each of the cells and the source line SL (see IG. 15) to connect the source S of each of the cells are formed so as to extend in the perpendicular direction to the paper surface and connected as shown in FIG. 15.

### [Operation of storage device]

Next, an operation at the time of set of a memory cell array (a storage device) according to the embodiment is described using FIG. 15. As described previously, set is a writing process from high resistance to low resistance. First, a selection transistor 12 is turned on, the selection transistor 12 being connected to a bit line BL1 connected to a selected memory cell 10a shown in FIG. 15 with broken lines surrounding the selected memory cell 10a. Then (or simultaneously therewith), a voltage is applied to a word line WL1 being connected to a gate G of a cell selection transistor 11a connected to the CB-RAM device 10a, so that the cell selection transistor 11a is turned on. The bias voltage to be applied to the selection bit line BL1 is set to have a positive value with respect to a source line SL1 (is set to be negative in a case that an upper electrode is the electrode B), and the absolute value thereof is set to be equal to or slightly greater than the absolute value of a voltage required for set.

The source line SL1 being connected to the selected memory cell 10a can be brought to be at a reference potential, or a ground potential 0V, for example, to create a current path from a bias voltage of the bit line BL1 to a ground potential via the bit line selection transistor 12, the cell selection transistor 11, and the CB-RAM device 10a, and, in accordance with the ratio of a resistance R of the CB-RAM device 10a in the high resistance state, a channel resistance r of the cell selection transistor 11, and the channel resistance of the bit line selection transistor 12, the bias voltage is divided to the CB-RAM device 10 and the channel resistance r' of the bit line selection transistor 12. The sum of r and r' is smaller than R, and r and r' are set to be greater than the resistance R' of the CB-RAM device 10 in the low resistance state. In other words, they are set such that R'<r+r'<R is satisfied. The resistance of the CB-RAM device 10a decreases from R to R' at the instance of set, so that current flowing through the CB-RAM device 10a immediately after the set is controlled by r+r'. Thereafter, once the bias voltage is brought back to 0V, reset is completed.

On the other hand, while reset being the switching process from low resistance to high resistance is also carried out with the same procedure as that for the set process, the point to be kept in mind is that the bias voltage (with respect to the source line BL1) to be applied to the selection bit line BL1 will have positive and negative reversed with respect to the case of the set. In other words, in a case of an upper electrode being the electrode A, the bias voltage to be applied to the selection bit line BL1 is set to have a negative value with respect to the source line SL1. For example, the selection bit line BL1 is set to be at the ground potential 0V and the source line SL1 is set to have a positive value. Thereafter, once the bias voltage is brought back to 0V, the reset is completed.

For reading, the gate voltage is adjusted such that both channel resistances of the cell selection transistor 11a and the bit line selection transistor 12 are brought to be sufficiently smaller than the value r of the low resistance of the CB-RAM device 10a, and detecting current flowing when a prespecified voltage is applied allows the resistance of the CB-RAM device 10a to be determined.

### [Variations of embodiment]

The invention is not limited to the above-described embodiments, so that a variety of variations are possible.

For example, such as material for an oxide film, film forming conditions, and a solvent to be used being recited in the above-described embodiments merely show one example, so that modifications or changes are possible as needed in accordance with the common general technical knowledge of a person skilled in the art.

Moreover, while an example being applied as a CB-RAM, or, in other words, a memory device, is shown in the above-described first embodiment, the invention is to provide a general technique to control diffusion of electrode A-constituting atoms in the insulator layer, the above-mentioned application is not to be limited to a memory, so that it can be applied to various devices.

### [Configuration of switching device]

For example, the above-described configuration of the memory cell 10 can be used as a switching device. In other words, the switching device comprises: a first metal layer including an electrochemically active and easily ionizable metal; a second metal layer including an electrochemically stable metal; an insulating layer being sandwiched between the first metal layer and the second metal layer and having a pore communicating from a first surface being in contact with the first metal layer to a second surface being in contact with the second metal layer; and an electrolyte layer being impregnated in the pore of the insulator layer, wherein the electrolyte layer contains a mixed ionic liquid in which is mixed a solvate ionic liquid, and a low-viscous ionic liquid being an ionic liquid having a viscosity coefficient smaller than that of the solvate ionic liquid. In other words, the configuration thereof is the same as that of the memory cell 10 shown in FIG. 2 as described previously. Conduction/non-conduction between the first metal layer 1 and the second metal layer 2 is controlled in accordance with the polarity of a voltage applied between the first metal layer and the second metal layer, functioning as a switching device.

### DESCRIPTION OF REFERENCE NUMERALS

1 FIRST METAL LAYER
2 SECOND METAL LAYER
3 INSULATOR LAYER
3a PORE
3b FIRST SURFACE
3c SECOND SURFACE
4 ELECTROLYTE LAYER
11 CELL SELECTION TRANSISTOR
12 BIT LINE SELECTION TRANSISTOR
WL, WL1, WL2: WORD LINE
BL, BL1, BL2: BIT LINE
SL, SL1, SL2: SOURCE LINE

## Claims

1. A conductive bridge memory device comprising:
a first metal layer (1) comprising an electrochemically active and easily ionizable metal;
a second metal layer (2) comprising an electrochemically stable metal;
an insulating layer being sandwiched between the first metal layer (1) and the second metal layer (2) and having a pore communicating from a first surface (3b) being in contact with the first metal layer (1) to a second surface (3c) being in contact with the second metal layer (2); and
an electrolyte layer (4) being impregnated in the pore of the insulator layer (3);
wherein the electrolyte layer (4) includes a mixed ionic liquid in which is mixed a solvate ionic liquid, and a low-viscous ionic liquid being an ionic liquid having a viscosity coefficient smaller than that of the solvate ionic liquid.

2. The conductive bridge memory device according to claim 1, wherein the insulating layer comprising a porous body, and the pore is an air pore of the porous body.

3. The conductive bridge memory device according to claim 1 or 2, wherein a solvent constituting the solvate ionic liquid is at least one type of solvent selected from the group consisting of: 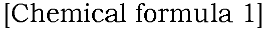 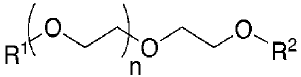 and 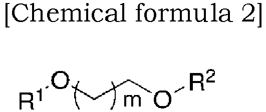 (where n is the number of ethyleneoxy groups being 1 or 2; m is the number of methylene groups, which is an integer being any one of 1 to 3; each of R¹, R² can be the same or different; R¹ denotes an alkyl group whose number of carbons is between 1 and 6, an alkenyl group whose number of carbons is between 2 and 6, an alkylnyl group whose number of carbons is between 2 and 6, a trimethysilyl group, a triethysilyl group, or a t-butyldimethylsilyl group; R² denotes an alkyl group whose number of carbons is between 1 and 16, an alkenyl group whose number of carbons is between 2 and 6, an alkylnyl group whose number of carbons is between 2 and 6, a trimethysilyl group, a triethysilyl group, or a t-butyldimethylsilyl group; and the alkenyl group can contain therein an ether functional group, a thioether functional group.).

4. The conductive bridge memory device according to any one of claims 1 to 3, wherein the low-viscous ionic liquid is at least one type selected from the group consisting of: 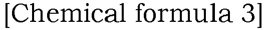 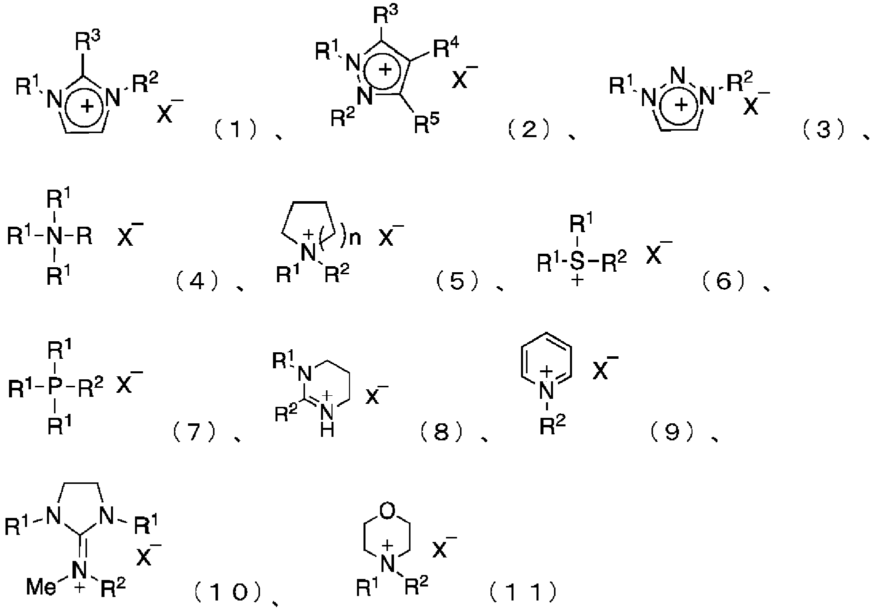 (where R¹ can be the same or different in the above-mentioned respective chemical formulas, and denotes an alkyl group whose number of carbons is between 1 and 6, or an alkenyl group whose number of carbons is between 2 and 6; R² can be the same or different in the above-mentioned respective chemical formulas, and denotes a hydrogen atom, an alkyl group whose number of carbons is between 1 and 16, an alkenyl group whose number of carbons is between 2 and 6, or an alkoxy group. The alkenyl group can contain therein an ether functional group, a thioether functional group. R³ can be the same or different in the above-mentioned respective chemical formulas, and denotes a hydrogen atom, a phenyl group, a methyl group, or an isopropyl group. n in chemical formula (5) denotes the number of methylene units, where n=1 or 2. In chemical formula (8), R¹ and R² can have carbon chains connected mutually, in which case they denote a trimethylene group, a tetramethylene group, a pentamethylene group, a hexamethylene group, or a heptamethylene group. Anion (X) in the ionic liquid can be the same or different in the above-mentioned respective chemical formulas, and denotes AlCl₄⁻, BF₄⁻, PF₆⁻, SbF₆⁻, N(SO₂CF₃)₂⁻, N(SO₂F)₂⁻, N(CN)₂⁻, MeSO₃⁻, MeSO₄⁻, CF₃SO₃⁻, NO₃⁻, CF₃COO⁻, RCOO⁻, RSO₄⁻, RCH(NH₂)COO⁻, SO₄²⁻, ClO₄⁻, Me₂PO₄⁻, (HF)_{2.3}F⁻. (Here, R denotes H, an alkyl group, an alkyloxy group.)).

5. The conductive bridge memory device according to any one of claims 1 to 4, wherein a/b being the mixing ratio of "a" moles of the solvate ionic liquid and "b" moles of the low-viscous ionic liquid is greater than or equal to 1 and less than or equal to 3.

6. The conductive bridge memory device according to any one of claims 1 to 5, wherein a metal salt or a metal ion of a metal being more difficult to be oxidized than a metal of the first metal layer (1) is mixed into the mixed ionic liquid.

7. The conductive bridge memory device according to claim 6, wherein the metal of the metal salt or the metal ion is selected from the group consisting of a silver ion, a gold ion, a palladium ion, a rhodium ion, a ruthenium ion, and a platinum ion.

8. The conductive bridge memory device according to any one of claims 1 to 7, wherein the insulator layer (3) is at least one type selected from the group consisting of a polycrystalline or amorphous of a metal oxide or a semiconductor oxide, including alumina, hafnia, silicon oxide, and a porous body being formed by a self-assembling phenomenon, including a metal organic framework.

9. The conductive bridge memory device according to any one of claims 1 to 8, wherein the insulating layer having the pore is an amorphous insulator layer (3).

10. The conductive bridge memory device according to claim 2, wherein the porosity of the porous body is greater than or equal to 10% and less than or equal to 80%.

11. The conductive bridge memory device according to any one of claims 1 to 10, wherein the size of the pore of the insulating layer is greater than or equal to 0.1 nm and less than or equal to 30 nm.

12. A switching device comprising:
a first metal layer (1) comprising an electrochemically active and easily ionizable metal;
a second metal layer (2) comprising an electrochemically stable metal;
an insulating layer being sandwiched between the first metal layer (1) and the second metal layer (2) and having a pore communicating from a first surface (3b) being in contact with the first metal layer (1) to a second surface (3c) being in contact with the second metal layer (2); and
an electrolyte layer (4) being impregnated in the pore of the insulator layer (3), wherein the electrolyte layer (4) includes a mixed ionic liquid in which is mixed a solvate ionic liquid, and a low-viscous ionic liquid being an ionic liquid having a viscosity coefficient smaller than that of the solvate ionic liquid;
wherein conduction/non-conduction between the first metal layer (1) and the second metal layer (2) can be controlled in accordance with the polarity of a voltage applied between the first metal layer (1) and the second metal layer (2).

13. A manufacturing method for a conductive bridge memory device, the manufacturing method comprising:
forming an insulating layer on a surface of a first metal layer (1) comprising an electrochemically active and easily ionizable metal, in which insulating layer a first surface is in contact with the surface of the first metal layer (1), the insulating layer having a pore communicating between the first surface (3b) and a second surface (3c) being opposite to the first surface (3b);
impregnating, in the pore (3a) of the insulating layer, an electrolyte material including a mixed ionic liquid in which is mixed a solvate ionic liquid, and a low-viscous ionic liquid being an ionic liquid having a viscosity coefficient smaller than that of the solvate ionic liquid; and
forming, on the second surface (3c) of the insulating layer in which the mixed ionic liquid is impregnated, a second metal layer (2) comprising an electrochemically stable metal.
